# EUROPEAN PATENT SPECIFICATION

(11) **EP 3 510 849 B1**
(45) Date of publication and mention of the grant of the patent: **30.08.2023**
(21) Application number: 17894894.9
(22) Date of filing: 03.02.2017
(51) Int. Cl.: G06F 1/20, H05K 7/20

(54) **THERMAL CONTROL WITH VAPOR AND ISOLATION CHAMBERS**
THERMISCHE STEUERUNG MIT DAMPF- UND ISOLIERUNGSKAMMERN
COMMANDE THERMIQUE AVEC CHAMBRES DE VAPEUR ET D'ISOLATION

(43) Date of publication of application: 17.07.2019
(73) Proprietor: Hewlett-Packard Development Company, L.P., Spring TX 77389 (US)
(72) Inventor: PETERSON, Alan D., Tomball, Texas 77375 (US); BLATT, David Isaac, Issaquah, Washington 98029 (US); PESCETTO, Michael James, Houston, Texas 77070 (US)
(74) Representative: Plasseraud IP
(86) International application number: PCT/US2017/016556
(87) International publication number: WO 2018/144020

(56) References cited:
- EP-A2- 2 154 938
- EP-A2- 2 779 229
- RU-C1- 2 528 567
- US-A1- 2002 105 784
- US-A1- 2006 157 227
- US-A1- 2011 024 086
- US-A1- 2013 208 421
- US-A1- 2016 286 693
- US-A1- 2016 286 693

## Description

### Background

An electronic device can include an electronic component that produces heat during operation of the electronic component. A thermal dissipation device can be included in the electronic device to dissipate heat produced by the electronic component away from the electronic component. US2016286693A1 discloses a cooled electronic system. EP2779229A2 discloses advanced cooling for power module switches. EP2154938A2 discloses a sustainable endothermic heat stripping method and apparatus. US2002105784A1 discloses a vacuum feedthrough heatpipe assembly. US2006157227A1 discloses a cooling device of thin plate type for preventing dry-out.

### Brief Description Of The Drawings

Some implementations of the present disclosure are described with respect to the following figures.
Fig. 1 is a schematic sectional view of a thermal control device according to some examples.
Fig. 2 is a schematic sectional view of a thermal control device according to further examples.
Fig. 3 is a schematic sectional view of an electronic device including a thermal control device according to some examples.
Fig. 4 is a flow diagram of a process of making a thermal control device, according to some examples.
Fig. 5 illustrates manufacturing stages for making a thermal control device according to some examples.

### Detailed Description

In the present disclosure, use of the term "a," "an", or "the" is intended to include the plural forms as well, unless the context clearly indicates otherwise. Also, the term "includes," "including," "comprises," "comprising," "have," or "having" when used in this disclosure specifies the presence of the stated elements, but do not preclude the presence or addition of other elements.

During use, an electronic device can be in contact with a human user. For example, a handheld electronic device can be held in a hand (or hands) of the user. Examples of handheld electronic devices include any or some combination of the following: a smartphone, a tablet computer, a game appliance, or any other device that are held by a user's hand(s) during use. Other examples of electronic devices that can be in contact with a part of a user during use can include: a wearable device (such as a smart watch, smart eyeglasses, a head-mounted device, and so forth), a notebook computer, and so forth. Although specific examples of electronic devices are listed above, it is noted that in further examples, there can be other examples of electronic devices that users make contact with during use.

A skin temperature of an electronic device can refer to a temperature of an outer surface of an external housing of the electronic device. If the skin temperature of the electronic device rises too high during operation of the electronic device, a user may experience discomfort or sustain injury if the user makes contact with the part of the external housing that has the elevated skin temperature.

In accordance with the present disclosure, a handheld electronic device according to the appended claims is disclosed which comprises a thermal control device that is able to perform: (1) heat dissipation to remove heat away from an electronic component (to protect the electronic component from overheating), and (2) thermal isolation to prevent or reduce heat transfer to the outer surface of an external housing of an electronic device. In particular the invention relates to a handheld electronic device according to claim 1 and a method of making a handheld device according to claim 8. Preferred embodiments of the invention are defined by the dependent claims.

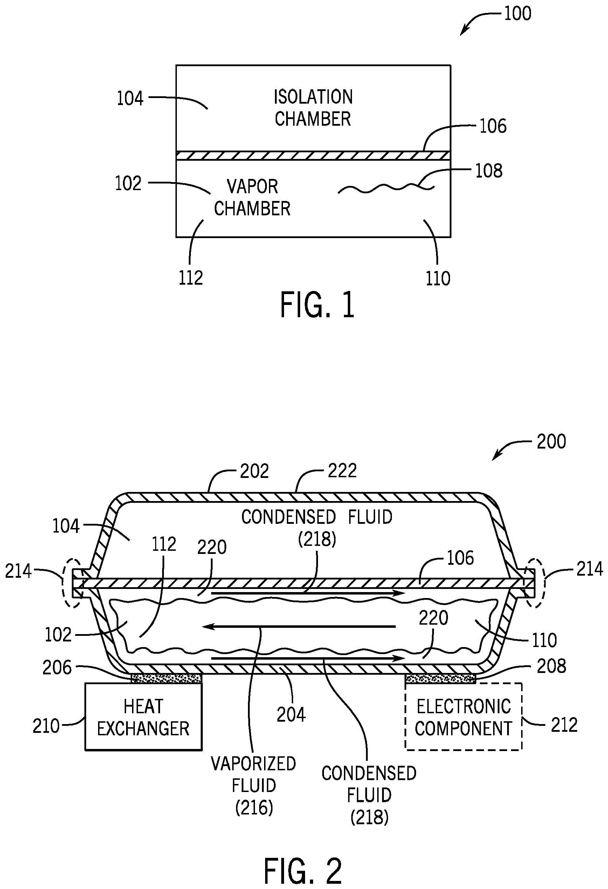

Fig. 1 is a schematic side view of a thermal control device 100 that includes a vapor chamber 102 and an isolation chamber 104 that is adjacent the vapor chamber 102. The isolation chamber 104 is "adjacent" the vapor chamber 102 if the isolation chamber 104 is positioned next to the vapor chamber 102. In some examples, the isolation chamber 104 and the vapor chamber 102 are integrally formed as part of the thermal control device 100. In other examples, the isolation chamber 104 and the vapor chamber 102 can be separate components that are attached together. In yet further examples, the isolation chamber 104 and the vapor chamber 102 are separate components that can be brought into contact with one another when assembled into an electronic device.

A barrier 106 is provided between the vapor chamber 102 and the isolation chamber 104 to fluidically isolate the isolation chamber 104 from the vapor chamber 102. The isolation chamber 104 is fluidically isolated from the vapor chamber 102 if fluid in the vapor chamber 112, including a working fluid 108, cannot pass to the isolation chamber 104. The barrier 106 can be formed of a metal, such as titanium, copper, or any other material that is impermeable to a fluid, including gas and/or liquid.

The working fluid 108 in the vapor chamber 102 is used to transport heat from a first portion 110 of the vapor chamber 102 to a second portion 112 of the vapor chamber. Examples of the working fluid 108 can include any or some combination of the following: water, ammonia, acetone, nitrogen, methanol, or any other fluid that vaporizes when heated and condenses when cooled. The presence of the barrier 106 prevents the working fluid 108 from entering the isolation chamber 104.

The isolation chamber 104 is evacuated to a pressure that is less than atmospheric pressure, which is the pressure of the atmosphere in which the thermal control device 100 is located. More specifically, the isolation chamber 104 can be evacuated to a vacuum. The isolation chamber 104 is considered to contain a vacuum if, during manufacture of the thermal control device 100, a fluid (gas and/or liquid) in the isolation chamber 104 is evacuated, which causes the pressure of the isolation chamber 104 to drop below the atmospheric pressure. It is noted that after evacuation of the isolation chamber 104, some small amount of a fluid (e.g., gas) may remain in the isolation chamber 104. However, in some examples, the isolation chamber 104 can be free of any liquid.

Whereas the vapor chamber 102 is filled with a sufficient amount of the working fluid 108 to allow the vapor chamber 102 to perform heat transfer between different locations (for the purpose of dissipating heat from a heat-producing component thermally contacted to the vapor chamber 102), fluid is evacuated from the isolation chamber 104 to prevent or reduce heat transfer through the isolation chamber 104.

The isolation chamber 104 is to thermally isolate at least a portion of the vapor chamber 102, such that heat in this portion of the vapor chamber 102 is thermally isolated by the isolation chamber 104 from another region. For example, the isolation chamber 104 provides thermal isolation between the vapor chamber 102 and a surface that is in thermal conductive contact with the isolation chamber 104. This surface can be an external surface of an electronic device in which the thermal control device 100 is provided, or the surface can be a different surface.

Fig. 2 is a schematic sectional view of a thermal control device 200 according to further examples. The thermal control device 200 includes a housing portion 202 and a housing portion 204 that are attached together to form a housing of the thermal control device 200.

The thermal control device 200 includes the vapor chamber 102 and the isolation chamber 104. In addition the thermal control device 200 includes a thermal interface 206 that is thermally contacted to the outer surface of the housing portion 204 near the second portion 112 of the vapor chamber 102, and a thermal interface 208 thermally contacted to the outer surface of the housing portion 204 near the first portion 110 of the vapor chamber 102. The thermal interface 206 or 208 can be formed of a thermally conductive material, such as thermal paste, a thermal adhesive, or any other layer through which heat can be conducted.

The thermal control device 200 also includes a heat exchanger 210 that is thermally contacted to the thermal interface 206. The heat exchanger 210 can include a heat spreader to spread heat away from the vapor chamber 102. For example, a heat spreader can include a heat sink that has fins or other types of heat dissipation surfaces. In some examples, the heat exchanger 210 can also include an airflow generator, such as a fan, to produce an airflow to carry heat away from the vapor chamber 102. Heat transferred to the second portion 112 of the vapor chamber 102 is communicated through the thermal interface 206 to the heat exchanger 210, which dissipates the heat away from the vapor chamber 102. The vapor chamber 102 is in thermal conductive contact with the heat exchanger 210, since heat transfer is possible between the vapor chamber 102 and the heat exchanger 210 through the thermal interface 206.

The thermal interface 208 is thermally contacted to an electronic component 212 that can produce heat during operation of the electronic component 212. Heat from the electronic component 212 is passed through the thermal interface 208 to the vapor chamber 102. For example, the electronic component 212 can include a processor, such as a microprocessor, a microcontroller, a programmable integrated circuit device, a programmable gate array, and so forth. Alternatively, the electronic component 212 can include a memory device, an input/output (I/O) device, or any other type of electronic component that can produce heat during operation. The vapor chamber 102 is in thermal conductive contact with the electronic component 212, since heat transfer is possible between the vapor chamber 102 and the electronic component 212 through the thermal interface 208.

It is noted that the electronic component 212 is not part of the thermal control device 200, and thus is shown in dashed profile.

The housing portions 202 and 204 are attached together at attachment points 214. In some examples, the housing portions 202 and 204 can be attached together by welding, by crimping, by soldering, by brazing, by use of adhesives, by bolting, or by any other attachment mechanism. Note that the barrier 106 can also be attached together with the housing portions 202 and 204 at attachment points 214. Attaching the housing portions 202 and 204 together seals the vapor chamber 102 and the isolation chamber 104.

The vapor chamber 102 includes a path through which vaporized fluid 216 can flow from the first portion 110 of the vapor chamber 102 to the second portion 112 of the vapor chamber 102. The vaporized fluid 216 is generated when heat from the electronic component 212 vaporizes a liquid that is located at the first portion 110 of the vapor chamber 102. The path through which the vaporized fluid 216 can flow can include a channel (or multiple channels).

The vaporized fluid 216 is condensed at the second portion 112 of the vapor chamber 102, due to cooling caused by the heat exchanger 210. The condensed fluid 218 (which is in liquid form) is carried by capillary action along a wick structure 220 that lines an inner surface of the vapor chamber 102. In examples according to Fig. 2, the wick structure 220 can be attached to a surface of the barrier 106 and an inner surface of the housing portion 204. In other examples, the wick structure 220 can be attached to just the inner surface of the housing portion 204, and not to the surface of the barrier 106.

The wick structure 220 includes small fluid paths that allow for the condensed fluid 218 to be transported by capillary action along the small fluid paths. When the condensed fluid 218 reaches the first portion 110 of the vapor chamber 102, the condensed fluid 218 vaporizes to become the vaporized fluid 216 in response to heat from the electronic component 212.

The presence of the isolation chamber 104 serves to provide thermal isolation between the chamber 102 and an external surface 222 of the housing portion 104 that is farthest away from the vapor chamber 102. In some examples, the external surface 222 of the housing portion 202 can form an external surface of the electronic device in which the thermal control device 200 is located. Alternatively, the external surface 222 of the housing portion 202 can make contact with the external housing of the electronic device. The thermal isolation provided by the isolation chamber 104 allows the external surface 222 of the housing portion 204 to remain at a lower temperature than the vapor chamber 102, which reduces the likelihood of an elevated skin temperature of an electronic device that can cause discomfort or injury to a user of the electronic device.

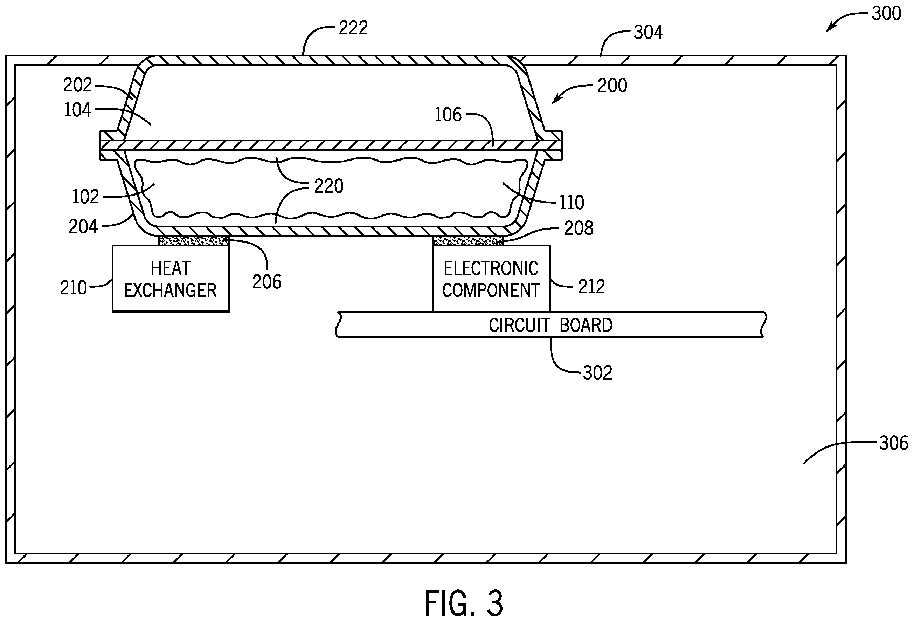

Fig. 3 is a schematic sectional view of an electronic device 300 that includes the thermal control device 200 and other components, including the electronic component 212 and a circuit board 302 on which the electronic component 212 is mounted. Additional electronic components (not shown) can also be mounted on the circuit board 302, where such additional electronic components can also be thermally contacted to the vapor chamber 102 (or to another thermal control device not shown).

Components shown in Fig. 3 that are in common with the components of Fig. 2 are assigned the same reference numerals. The electronic device 300 includes an external housing 304, which defines an inner chamber 306 in which the thermal control device 200, the electronic component 212, and the circuit board 302 are located. In examples according to Fig. 3, the external surface 222 of the housing portion 202 of the thermal control device 200 forms a part of the external surface of the electronic device 300. In other examples, the housing portion 202 of the thermal control device 200 is not exposed outside the electronic device housing 304, but instead, the external surface 222 of the housing portion 202 of the thermal control device 200 can be contacted to the external housing 304 of the electronic device 300.

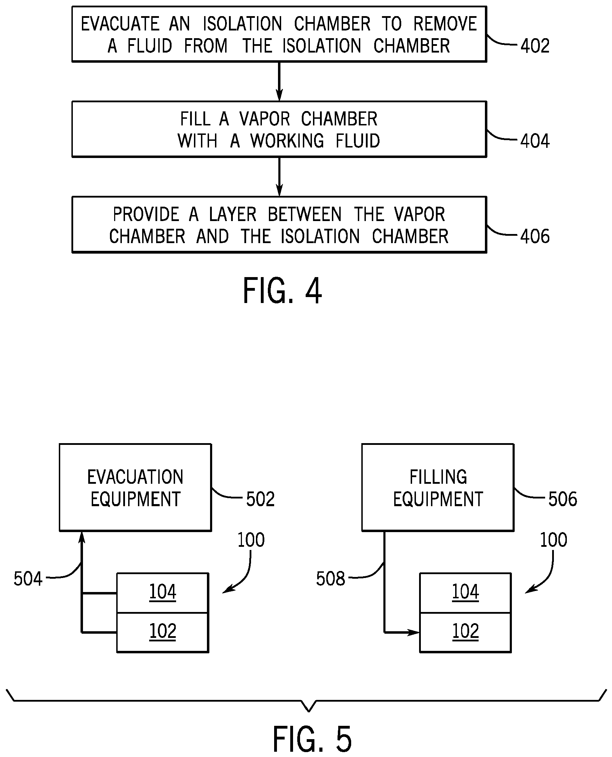

Fig. 4 is a flow diagram of a process of making a thermal control device (e.g., 100 or 200 in Fig. 1 or 2), according to some examples. The process of Fig. 4 includes evacuating (at 402) an isolation chamber (e.g., the isolation chamber 104) to remove fluid from the isolation chamber.

The process of Fig. 4 further includes filling (at 404) a vapor chamber (e.g., the vapor chamber 102) with a working fluid for transporting heat from a first portion of the vapor chamber to a second portion of the vapor chamber. The process further includes providing (at 406) a layer (e.g., the barrier 106) between the vapor chamber and the isolation chamber, the layer fluidically isolating the isolation chamber from the vapor chamber.

In addition, although not shown in Fig. 4, the process can further evacuate the vapor chamber to remove a fluid from the vapor chamber prior to filling (at 404) the vapor chamber with the working fluid. The evacuating of the isolation chamber (at 402) and the evacuating of the vapor chamber can be performed together.

Further, the process attaches housing portions together to form a housing that defines the vapor chamber and the isolation chamber, where the layer is provided within the housing. In some examples, the layer can be attached to the housing portions. The attachment of the housing portions together seals the vapor chamber and the isolation chamber.

Fig. 5 is a schematic diagram that shows various manufacturing stages for making the thermal control device 100 according to some examples. The manufacturing stages include manufacturing equipment, such as evacuation equipment 502 and filling equipment 506. There are other manufacturing stages (and their respective manufacturing equipment) for making a thermal control device that are not shown in Fig. 5.

The evacuation equipment 502 is used to evacuate the vapor chamber 102 and the isolation chamber 104 of the thermal control device. For example, the evacuation equipment 502 can be connected to inlet ports of the vapor chamber 102 and the isolation chamber 104 over a fluid path 504. The evacuation equipment 502 can be activated to evacuate any fluid inside the vapor chamber 102 and isolation chamber 104 along the fluid path 504. For example, the evacuation equipment 502 can include a pump to draw down pressure that causes fluids inside the vapor chamber 102 and the isolation chamber 104 to flow out of the chambers and along the path 504 to a fluid exit (not shown). In some examples, the evacuation equipment 502 is able to evacuate the vapor chamber 102 and the isolation chamber 104 to a vacuum.

In accordance with some examples, the vapor chamber 102 and the isolation chamber 104 can be evacuated together as part of the same evacuation operation performed by the evacuation equipment 502. This simplifies the manufacturing process of the thermal control device 100 by avoiding the use of separate operations to evacuate the vapor and isolation chambers. By simplifying the manufacturing process, the cost associated with making the thermal control device 100 can be reduced.

Once the isolation chamber 104 has been evacuated to a vacuum, the inlet port to the isolation chamber 104 can be plugged to seal the isolation chamber 104. Next, the filling equipment 506 is used to inject a working fluid along a fluid path 508 through the inlet port of the vapor chamber 102, to partially fill the vapor chamber 102 with the working fluid. Once the vapor chamber 102 has been filled with the working fluid, the inlet port to the vapor chamber 102 can be plugged to seal the vapor chamber 102.

Although Fig. 5 shows just the evacuation equipment 502 and the filling equipment 506, it is noted that the manufacturing process to make the thermal control device 100 can involve other manufacturing equipment, including equipment to form the housing portions of the thermal control device 100 and to add the barrier 106, equipment to attach the housing portions and barrier together, and so forth.

In addition to being relatively cost effective to make, the thermal control device 100 also does not add substantial weight to an electronic device in which the thermal control device 100 is included. The isolation chamber 104 is effectively an empty container with a very small amount of fluid (e.g., trace amounts of fluid), and thus would not add substantially to the overall weight of the thermal control device as compared to a thermal control device that omits the isolation chamber 104 but includes other components of the thermal control device (such as the vapor chamber 102, the heat exchanger 210, etc.).

## Claims

1. A handheld electronic device (200) comprising:
an electronic component (212) that produces heat during operation; and
a thermal control device (100) for dissipating the heat produced by the electronic component away from the electronic component, comprising:
a vapor chamber (102) comprising a fluid (108) to transport heat from a first portion (110) of the vapor chamber (102) to a second portion (112) of the vapor chamber (102); and
an isolation chamber (104) adjacent the vapor chamber (102) and fluidically isolated from the vapor chamber (102), the isolation chamber (104) evacuated to a pressure less than atmospheric pressure to thermally isolate at least a portion of the vapor chamber (102), wherein a surface of the thermal control device (100) forms an outer housing surface of the electronic device (200).

2. The handheld electronic device (200) of claim 1, whereby the thermal control device (100) further comprises a housing (202, 204) containing the vapor chamber (102) and the isolation chamber (104), and a layer (106) between the vapor chamber (102) and the vacuum chamber (104), the layer (106) impermeable to fluid.

3. The handheld electronic device (200) of claim 2, whereby the layer (106) comprises a metal.

4. The handheld electronic device (200) of claim 1, wherein the isolation chamber (104) is free of a liquid.

5. The handheld electronic device (200) of claim 1, wherein the fluid (108) in the vapor chamber (102) is to vaporize in response to heat produced by the electronic component (212) in thermal conductive contact with the first portion (110) of the vapor chamber (102), and the vaporized fluid is to condense at the second portion (112) of the vapor chamber, and wherein the condensed fluid is to be transported by capillary action from the second portion (112) to the first portion (110).

6. The handheld electronic device (200) of claim 1, wherein the isolation chamber (104) provides thermal isolation between the vapor chamber (102) and a surface in thermal conductive contact with the isolation chamber (104).

7. The handheld electronic device (200) of claim 1, whereby the thermal control device (100) further comprises:
a heat exchanger (210) in thermal conductive contact with the second portion (112) of the vapor chamber (102).

8. A method of making a handheld electronic device (200) according to any of the above claims, comprising:
providing an electronic component (212) that produces heat during operation;
providing a thermal control device (100) for dissipating the heat produced by the electronic component away from the electronic component, said thermal control device comprising an isolation chamber (104) and a vapor chamber (102) adjacent each other;
evacuating (402) the isolation chamber (104) to remove fluid from the isolation chamber (104) to a pressure less than atmospheric pressure to thermally isolate at least a portion of the vapor chamber;
filling (404) the vapor chamber (102) with a working fluid (108) for transporting heat from a first portion (110) of the vapor chamber (102) to a second portion (112) of the vapor chamber (102); and
providing (406) a layer (106) between the vapor chamber (102) and the isolation chamber (104), the layer (106) fluidically isolating the isolation chamber (104) from the vapor chamber (102); whereby a surface of the thermal control device forms an outer housing surface of the electronic device (200).

9. The method of claim 8, further comprising:
evacuating the vapor chamber (102) to remove a fluid from the vapor chamber (102); and
after the evacuating of the vapor chamber (102), performing the filling of the vapor chamber (102) with the working fluid (108).

10. The method of claim 9, wherein the evacuating of the isolation chamber (104) and the evacuating of the vapor chamber (102) are performed together.

11. The method of claim 8, further comprising:
attaching housing portions (202, 204) together to form a housing that defines the vapor chamber (102) and the isolation chamber (104), the layer being provided within the housing (202, 204).

12. The method of claim 11, further comprising:
attaching the layer (106) to the housing portions (202, 204).

13. The method of claim 11, wherein attaching the housing portions (202, 204) together seals the vapor chamber (102) and the isolation chamber (104).

## Patentansprüche

1. Tragbare elektronische Vorrichtung (200), die Folgendes umfasst:
eine elektronische Komponente (212), die Wärme während des Betriebs erzeugt, und
eine thermische Steuervorrichtung (100) zum Ableiten der durch die elektronische Komponente erzeugten Wärme von der elektronischen Komponente weg, die Folgendes umfasst:
eine Dampfkammer (102), die ein Fluid (108) umfasst, um Wärme von einem ersten Abschnitt (110) der Dampfkammer (102) zu einem zweiten Abschnitt (112) der Dampfkammer (102) zu transportieren; und
eine Isolierkammer (104) angrenzend an die Dampfkammer (102) und von der Dampfkammer (102) fluidisch isoliert, wobei die Isolierkammer (104) mit einem Druck entleert wird, der kleiner als Atmosphärendruck ist, um mindestens einen Abschnitt der Dampfkammer (102) thermisch zu isolieren, wobei eine Oberfläche der thermischen Steuervorrichtung (100) eine äußere Gehäuseoberfläche der elektronischen Vorrichtung (200) ausbildet.

2. Tragbare elektronische Vorrichtung (200) nach Anspruch 1, wobei die thermische Steuervorrichtung (100) ferner ein Gehäuse (202, 204) umfasst, das die Dampfkammer (102) und die Isolierkammer (104) und eine Schicht (106) zwischen der Dampfkammer (102) und der Vakuumkammer (104) umfasst, wobei die Schicht (106) für Fluid undurchlässig ist.

3. Tragbare elektronische Vorrichtung (200) nach Anspruch 2, wobei die Schicht (106) ein Metall umfasst.

4. Tragbare elektronische Vorrichtung (200) nach Anspruch 1, wobei die Isolierkammer (104) frei von einer Flüssigkeit ist.

5. Tragbare elektronische Vorrichtung (200) nach Anspruch 1, wobei das Fluid (108) in der Dampfkammer (102) dazu dient, als Reaktion auf Wärme, die durch die elektronische Komponente (212) in thermisch leitfähigem Kontakt mit dem ersten Abschnitt (110) der Dampfkammer (102) erzeugt wird, zu verdampfen, und das verdampfte Fluid dazu dient, an dem zweiten Abschnitt (112) der Dampfkammer zu kondensieren, und wobei das kondensierte Fluid dazu dient, durch Kapillarwirkung von dem zweiten Abschnitt (112) zu dem ersten Abschnitt (110) transportiert zu werden.

6. Tragbare elektronische Vorrichtung (200) nach Anspruch 1, wobei die Isolierkammer (104) eine thermische Isolierung zwischen der Dampfkammer (102) und einer Oberfläche in thermisch leitfähigem Kontakt mit der Isolierkammer (104) bereitstellt.

7. Tragbare elektronische Vorrichtung (200) nach Anspruch 1, wobei die thermische Steuervorrichtung (100) ferner Folgendes umfasst:
einen Wärmetauscher (210) in einem thermisch leitfähigem Kontakt mit dem zweiten Abschnitt (112) der Dampfkammer (102).

8. Verfahren zum Herstellen einer tragbaren elektronischen Vorrichtung (200) nach einem der vorstehenden Ansprüche, das Folgendes umfasst:
Bereitstellen einer elektronischen Komponente (212), die während des Betriebs Wärme erzeugt;
Bereitstellen einer thermischen Steuervorrichtung (100) zum Ableiten der durch die elektronische Komponente erzeugten Wärme von der elektronischen Komponente weg, wobei die thermische Steuervorrichtung eine Isolierkammer (104) und eine Dampfkammer (102) angrenzend aneinander umfasst;
Entleeren (402) der Isolierkammer (104), um Fluid aus der Isolierkammer (104) mit einem Druck zu entfernen, der kleiner als Atmosphärendruck ist, um mindestens einen Abschnitt der Dampfkammer thermisch zu isolieren;
Füllen (404) der Dampfkammer (102) mit einem Arbeitsfluid (108) zum Transportieren von Wärme von einem ersten Abschnitt (110) der Dampfkammer (102) zu einem zweiten Abschnitt (112) der Dampfkammer (102); und
Bereitstellen (406) einer Schicht (106) zwischen der Dampfkammer (102) und der Isolierkammer (104), wobei die Schicht (106) die Isolierkammer (104) von der Dampfkammer (102) fluidisch isoliert; wobei eine Oberfläche der thermischen Steuervorrichtung eine äußere Gehäuseoberfläche der elektronischen Vorrichtung (200) ausbildet.

9. Verfahren nach Anspruch 8, das ferner Folgendes umfasst:
Entleeren der Dampfkammer (102), um ein Fluid aus der Dampfkammer (102) zu entfernen; und
nach dem Entleeren der Dampfkammer (102), Durchführen des Füllens der Dampfkammer (102) mit dem Arbeitsfluid (108).

10. Verfahren nach Anspruch 9, wobei das Entleeren der Isolierkammer (104) und das Entleeren der Dampfkammer (102) zusammen durchgeführt werden.

11. Verfahren nach Anspruch 8, das ferner Folgendes umfasst:
Anbringen von Gehäuseabschnitten (202, 204) miteinander, um ein Gehäuse auszubilden, das die Dampfkammer (102) und die Isolierkammer (104) definiert, wobei die Schicht innerhalb des Gehäuses (202, 204) bereitgestellt ist.

12. Verfahren nach Anspruch 11, das ferner Folgendes umfasst:
Anbringen der Schicht (106) an den Gehäuseabschnitten (202, 204).

13. Verfahren nach Anspruch 11, wobei ein Anbringen der Gehäuseabschnitte (202, 204) miteinander die Dampfkammer (102) und die Isolierkammer (104) abdichtet.

## Revendications

1. Dispositif électronique portatif (200) comprenant :
un composant électronique (212) qui produit de la chaleur pendant le fonctionnement ; et
un dispositif de régulation thermique (100) pour dissiper la chaleur produite par le composant électronique loin du composant électronique, comprenant :
une chambre à vapeur (102) comprenant un fluide (108) pour transporter de la chaleur depuis une première partie (110) de la chambre à vapeur (102) vers une seconde partie (112) de la chambre à vapeur (102) ; et
une chambre d'isolation (104) adjacente à la chambre à vapeur (102) et isolée fluidiquement de la chambre à vapeur (102), la chambre d'isolation (104) étant évacuée à une pression inférieure à la pression atmosphérique pour isoler thermiquement au moins une partie de la chambre à vapeur (102), dans lequel une surface du dispositif de régulation thermique (100) forme une surface de boîtier externe du dispositif électronique (200).

2. Dispositif électronique portatif (200) selon la revendication 1, moyennant quoi le dispositif de régulation thermique (100) comprend en outre un boîtier (202, 204) contenant la chambre à vapeur (102) et la chambre d'isolation (104), et une couche (106) entre la chambre à vapeur (102) et la chambre à vide (104), la couche (106) étant imperméable au fluide.

3. Dispositif électronique portatif (200) selon la revendication 2, moyennant quoi la couche (106) comprend un métal.

4. Dispositif électronique portatif (200) selon la revendication 1, dans lequel la chambre d'isolation (104) est exempte de liquide.

5. Dispositif électronique portatif (200) selon la revendication 1, dans lequel le fluide (108) dans la chambre à vapeur (102) doit se vaporiser en réponse à la chaleur produite par le composant électronique (212) en contact thermoconducteur avec la première partie (110) de la chambre à vapeur (102), et le fluide vaporisé doit se condenser au niveau de la seconde partie (112) de la chambre à vapeur, et dans lequel le fluide condensé doit être transporté par action capillaire de la seconde partie (112) vers la première partie (110).

6. Dispositif électronique portatif (200) selon la revendication 1, dans lequel la chambre d'isolation (104) fournit une isolation thermique entre la chambre à vapeur (102) et une surface en contact thermoconducteur avec la chambre d'isolation (104).

7. Dispositif électronique portatif (200) selon la revendication 1, moyennant quoi le dispositif de régulation thermique (100) comprend en outre :
un échangeur de chaleur (210) en contact thermoconducteur avec la seconde partie (112) de la chambre à vapeur (102).

8. Procédé de fabrication d'un dispositif électronique portatif (200) selon l'une quelconque des revendications précédentes, comprenant :
la fourniture d'un composant électronique (212) qui produit de la chaleur pendant le fonctionnement ;
la fourniture d'un dispositif de régulation thermique (100) pour dissiper la chaleur produite par le composant électronique loin du composant électronique, ledit dispositif de régulation thermique comprenant une chambre d'isolation (104) et une chambre à vapeur (102) adjacente l'une à l'autre ;
l'évacuation (402) de la chambre d'isolation (104) pour retirer le fluide de la chambre d'isolation (104) à une pression inférieure à la pression atmosphérique pour isoler thermiquement au moins une partie de la chambre à vapeur ;
le remplissage (404) de la chambre à vapeur (102) avec un fluide de fonctionnement (108) pour transporter de la chaleur depuis une première partie (110) de la chambre à vapeur (102) vers une seconde partie (112) de la chambre à vapeur (102) ; et
la fourniture (406) d'une couche (106) entre la chambre à vapeur (102) et la chambre d'isolation (104), la couche (106) isolant fluidiquement la chambre d'isolation (104) de la chambre à vapeur (102) ; moyennant quoi une surface du dispositif de régulation thermique forme une surface de boîtier externe du dispositif électronique (200).

9. Procédé selon la revendication 8, comprenant en outre :
l'évacuation de la chambre à vapeur (102) pour retirer un fluide de la chambre à vapeur (102) ; et
après l'évacuation de la chambre à vapeur (102), la réalisation du remplissage de la chambre à vapeur (102) avec le fluide de fonctionnement (108).

10. Procédé selon la revendication 9, dans lequel l'évacuation de la chambre d'isolation (104) et l'évacuation de la chambre à vapeur (102) sont réalisées ensemble.

11. Procédé selon la revendication 8, comprenant en outre :
la fixation des parties de boîtier (202, 204) ensemble pour former un boîtier qui définit la chambre à vapeur (102) et la chambre d'isolation (104), la couche étant placée à l'intérieur du boîtier (202, 204).

12. Procédé selon la revendication 11, comprenant en outre :
la fixation de la couche (106) aux parties de boîtier (202, 204).

13. Procédé selon la revendication 11, dans lequel la fixation des parties de boîtier (202, 204) ensemble scelle la chambre à vapeur (102) et la chambre d'isolation (104).
